**Europäisches Patentamt**

**European Patent Office**

**Office européen des brevets**

(11) Veröffentlichungsnummer : **0 290 539 B1**

(12) **EUROPÄISCHE PATENTSCHRIFT**

(45) Veröffentlichungstag der Patentschrift :
**02.10.91 Patentblatt 91/40**

(51) Int. Cl.⁵ : **C23C 18/18**

(21) Anmeldenummer : **87907598.4**

(22) Anmeldetag : **20.11.87**

(86) Internationale Anmeldenummer :
**PCT/EP87/00720**

(87) Internationale Veröffentlichungsnummer :
**WO 88/03962 02.06.88 Gazette 88/12**

(54) **VERFAHREN ZUR CHEMISCHEN BEHANDLUNG VON KERAMIKKÖRPERN MIT NACHFOLGENDER METALLISIERUNG.**

(30) Priorität : **20.11.86 DE 3639642**

(43) Veröffentlichungstag der Anmeldung :
**17.11.88 Patentblatt 88/46**

(45) Bekanntmachung des Hinweises auf die
Patenterteilung :
**02.10.91 Patentblatt 91/40**

(84) Benannte Vertragsstaaten :
**AT BE CH DE FR GB IT LI LU NL SE**

(56) Entgegenhaltungen :
**EP-A- 0 128 476**
**EP-A- 0 133 201**
**EP-A- 0 210 437**
**DE-A- 3 523 958**

(73) Patentinhaber : **Licentia**
**Patent-Verwaltungs-GmbH**
**Theodor-Stern-Kai 1**
**W-6000 Frankfurt/Main 70 (DE)**
Patentinhaber : **SCHERING**
**AKTIENGESELLSCHAFT Berlin und**
**Bergkamen**
**Müllerstrasse 170/178 Postfach 65 03 11**
**W-1000 Berlin 65 (DE)**

(72) Erfinder : **BOGENSCHÜTZ, August, Friedrich**
**Beethovenstra e 10**
**W-7931 Oberdischingen (DE)**
Erfinder : **OSTWALD, Robert**
**Hasensteige 8**
**W-7900 Ulm (DE)**

(74) Vertreter : **Amersbach, Werner, Dipl.-Ing. et al**
**Licentia Patent-Verwaltungs-GmbH**
**Theodor-Stern-Kai 1**
**W-6000 Frankfurt 70 (DE)**

**Beschreibung**

Die Erfindung betrifft ein Verfahren zur chemischen Behandlung von Keramikkörpern mit nachfolgender Metallisierung nach dem Oberbegriff des Patentanspruchs 1

Ein derartiges Verfahren ist bekannt aus der DE-A1-3523958, entspricht EP-A1-209748. Das dort beschriebene Verfahren insbesondere zur haftfesten Metallisierung von plattenförmigen Keramikkörpern geeignet, die als Substrate für gedruckte Schaltungen in der Elektrotechnik verwendet werden. Bei einem derartigen Anwendungsfall ist es besonders wichtig, daß die Keramikkörper in genau gleichbleibender Weise zunächst vorbehandelt werden, so daß insbesondere die sogenannte Brennhaut entfernt wird und eine genau definierte Aufrauhung der Oberfläche erfolgt. Dieses erfolgt mit Hilfe einer Alkalihydroxidschmelze, der insbesondere eine genau definierte Wassermenge zugesetzt wird.

Der Erfindung liegt die Aufgabe zugrunde, eine weitere Ausbildung der Erfindung gemäß DE-A1-3523958 anzugeben.

Diese Aufgabe wird gelöst durch die im kennzeichnenden Teil des Patentanspruchs 1 angegebenen Merkmale.

Zweckmäßige Ausgestaltungen sind den Unteransprüchen entnehmbar.

Die Erfindung geht aus von der Erkenntnis, daß eine entscheidende Voraussetzung für eine gleichmäßige und zuverlässig hohe Belegungsdichte von katalytischen Keimen sowie eine gleichmäßig hohe Haftfestigkeit der stromlos-chemisch abgeschiedenen Kupferschicht darin besteht, eine bezüglich Reinigung, Benetzbarkeit und aufrauhenden Ätzangriff der Keramikoberfläche reproduzierbare Vorbehandlung zu erreichen, was in bekannten Verfahren unberücksichtigt ist.

Die Erfindung wird im folgenden anhand von Ausführungsbeispielen näher erläutert.

Die Erfindung beruht darauf, daß insbesondere die sogenannte "glasartige Brennhaut", welche die meisten keramik-Qualitäten chemisch inert macht, reproduzierbar entfernt wird. Nach diesem Verfahren werden die Keramikoberflächen nicht nur gereinigt, sondern vielmehr durch einen Abtragungsprozeß chemischer Art aktiviert, damit chemische Bindungen zu den Oberflächen freigelegter Keramikkristalle erfolgen können. Dieser Abtragungsprozeß darf die Oberflächen aber weder zu stark aufrauhen, noch das Material-gefüge lockern, da anderenfalls die erforderlichen mechanischen Verankerungen zu leicht ausbrechen. Ein chemischer Ätzprozeß, durch den primär die "glasartige Brennhaut" entfernt wird, ist daher am geeignetsten. Für das in der Elektronik am meisten angewandte Keramik-Substratmaterial Aluminiumoxid sind aus der Literatur (vgl. z.B. R. Bock : Aufschlußmethoden der anorganischen und organischen Chemie, Verlag Chemie, Weinheim/Bergstraße, 1972) eine Reihe von Ätzmitteln bekannt, so z.B. Phosphor-, Schwefel-, Salpeter- und Flußsäure oder Ammoniumhydrogenfluorid sowie auch Natronlauge oder eine Natriumhydroxid-Schmelze. Die Säuren erweisen sich aber in der Regel als zu wenig wirksam, während die Alkalien erst bei sehr hoher Temperatur, dann aber bereits zu stark oder ungleichmäßig, die Keramikoberfläche angreifen. Wird das z.B. aus der DE-OS 3150399 oder EP-A-0128476 bekannte Verfahren einer Tauchbeschichtung mit Natronlauge angewandt, so muß eine derart hergestellte Schicht erst eingetrocknet werden, wobei die Gefahr der Karbonatisierung besteht, und dann bei sehr hoher Temperatur (ca. 500°C) gebrannt werden, wobei die geringen Alkalihydroxidmengen sich ungleichmäßig verteilen und schnell mit der Unterlage abreagieren, so daß kein weiterer Ätzangriff erfolgen kann. Auch bei dem Verfahren einer Tauchbehandlung in einer Schmelze von Natriumhydroxid kann selbst bei über dem Schmelzpunkt von NaOH (Fp = 318°C) liegenden Temperaturen kein wesentlich stärkerer Ätzangriff erfolgen.

Es wurde gefunden, daß sich der Ätzangriff der NaOH-KOH- Schmelze bereits durch einen relativ geringen Wassergehalt beträchtlich steigern läßt. Es wurde außerdem gefunden, daß sich durch den gesteigerten Ätzangriff die Oberfläche auch von Aluminiumnitrid-Keramik viel stärker und vor allem gleichmäßiger aufrauhen läßt und durch den dadurch erhöhten Anteil der mechanischen Verankerungen bei Metallisierungen eine erhebliche Steigerung der Haftfestigkeit eintritt.

Eine mit einigen Prozenten Wasser angesetzte und frisch angewandte NaOH-Schmelze bewirkt zwar recht gute Aufrauhungen, ist aber in ihrer Wirkung sehr schwer zu reproduzieren. Ein konstanter und zugleich höherer Wassergehalt der NaOH-Schmelze ist dagegen durch eine Gasatmosphäre mit einem bestimmten Wasserdampfpartialdruck (wie in der DE-A-3523961 beschrieben) über der Schmelze zu erzielen. Wird mit dieser Atmosphäre zugleich dafür gesorgt, daß kein kohlendioxid zur Schmelze gelangen kann, so wird auch deren Karbonatisierung wirksam verhindert. Das Verfahren läßt sich ebenso gut auch mit den übrigen Alkalihydroxiden wie z.B LiOH und KOH oder Mischungen aus diesen durchführen. Das Verfahren ist nicht auf oxidische Keramiken beschränkt sondern auch auf andere Keramikarten wie z.B. Aluminiumnitrid, Siliciumnitrid oder Siliciumcarbid anwendbar.

Ein Schutz empfindlicher Keramikteile vor dem Zerspringen durch Temperaturschock bedingte Spannungen sowie eine weitere Steigerung der Ätzrate bzw. der Reproduzierbarkeit gelingt durch eine Vorwärmung der Keramikkörper vorzugsweise in der Schutzgasatmosphäre.

Die Erfindung soll anhand der folgenden Ausführungsbeispiele näher erläutert werden :

1. Ausführungsbeispiel :

Keramiksubstrate aus Aluminiumnitrid (98% Al N) mit den Abmessungen $25 \times 25 \times 1$ mm³ werden über einer schmelze aus 41 Gew.% NaOH und 59 Gew.% KOH (Eutektikum) bei 200°C für 15 min vorgewärmt und anschließend für 10 min in diese getaucht. Nach dem Herausziehen und Abkühlen werden die Substrate in einer 5%igen Natronlauge bei Ultraschallanregung nachbehandelt und anschließend in demineralisiertem Wasser gründlich gespült. Die mittlere Rauhtiefe der Keramikoberfläche hatte dadurch von ursprünglich 0,6 µm auf ca. 1.0 µm zugenommen.

Zwecks anschließender stromlos chemischer Metallisierung werden die Substrate nacheinander in eine Zinn (II)-chlorid-Lösung, in Wasser und in eine Palladiumchlorid-Lösung getaucht sowie abschließend in Wasser gespült, um in bekannter Weise mit katalytischen Keimen belegt zu werden. Es erfolgt dann die stromlos-chemische Abscheidung einer ungefähr 0,3 µm dicken Kupfer-Basisschicht aus einem derzeit handelsüblichen chemischen Kupfer-Formaldehyd-Bad sowie nach der Spülung die Verstärkung der Kupferschicht auf ca. 15 µm in einem derzeit handelsüblichen galvanischen kupfersulfat-Bad.

Zur Haltfestigkeitsprüfung werden an einer Keramikprobe fotoätztechnisch 1 mm breite Streifen präpariert, und mit einer Zugprüfmaschine wird die Kraft zum senkrechten Abschälen dieser Streifen gemessen. Es wird dabei eine Schälkraft von ungefähr 0,7 N/mm festgestellt. Ohne Vorbehandlung in der KOH-NaOH-Schmelze ist die Haftung der Kupferschicht ungleichmäßig und weist allenfalls eine Schälkraft von 0,1 N/mm auf.

2. Ausführungsbeispiel :

Aluminiumnitrid-Keramiksubstrate, wie in Beispiel 1, werden nach einer Vorwärmung auf 300°C 10 min lang in eine Natriumhydroxid-Schmelze getaucht, über welche zuvor 2 Std. lang ein Stickstoff- Wasserdampfstrom geleitet wurde. Die Temperatur der Schmelze betrug 320°C. Die Keramikproben hatten nach der Spülung und Trocknung eine mittlere Rauhigkeit von ungefähr 1,5 µm. Nach der Bekeimung dieser Proben wurde mit ungefähr 0,1 µm Nickel-Phosphor aus einem derzeit handelsüblichen Nickel-Hypophosphit-Bad vormetallisiert und nach der Spülung in einem Kupfersulfatbad auf ungefähr 15 µmSchichtdicke mit Kupfer galvanisch verstärkt. Nach der fotoätztechnischen Herstellung von 1 mm breiten Schälstreifen wurden Schälkräfte von 1,0 N/mm gemessen.

## Patentansprüche

1. Verfahren zur stromlos chemischen Metallisierung eines Keramikkörpers, dessen Oberfläche nach einer Behandlung mit einer Al-kalihydroxidschmelze stromlos chemisch insbesondere mit Kupfer metallisiert wird, so daß daraus eine elektrische Schaltung herstellbar wird, dadurch gekennzeichnet,
— daß die Keramikkörper zunächst vorgewärmt werden,
— daß die vorgewärmten Keramikkörper mit einer wasserhaltigen Alkalihydroxidschmelze behandelt werden während einer Zeit, die in einem Zeitbereich von 1 s bis 10 h liegt,
— daß die Behandlung in einer Schutzgasatmosphäre durchgeführt wird,
— daß die Keramikkörper anschließend mindestens bis zur Schmelztemperatur des Alkalihydroxids erwärmt, sowie einer Spülbehandlung unterzogen werden,
— daß daran anschließend die Metallisierung erfolgt,
— daß mindestens einer der Keramikkörper aus nitridhaltigem Material besteht,
— daß die Alkalihydroxidschmelze aus einer NaOH-KOH-Mischung gebildet wird und
— daß die Alkalihydroxidschmelze einen Wassergehalt von 0,01 bis 10 Gew.% hat.

2. Verfahren zur chemischen Behandlung von Keramikkörpern nach Anspruch 1, dadurch gekennzeichnet, daß mindestens einer der Keramikkörper aus Aluminiumnitrid-haltigem Material besteht.

3. Verfahren zur chemischen Behandlung von Keramikkörpern nach Anspruch 1 oder Anspruch 2, dadurch gekennzeichnet, daß die Alkalihydroxidschmelze aus einer eutektischen NaOH-KOH-Mischung (41 Gew.% NaOH) gebildet wird.

4. Verfahren zur chemischen Behandlung von Kermaikkörpern nach einem der vorhergehenden Ansprüche, dadurch gekennzeichnet, daß die Alkalihydroxidschmelze einen Wassergehalt von 1 Gew.% hat.

5. Verfahren zur chemischen Behandlung von Keramikkörpern nach einem der vorhergehenden Ansprüche, dadurch gekennzeichnet, daß die vorgewärmten Keramikkörper während einer Zeitdauer von 1 bis 30 min. mit einer wasserhaltigen Alkalihydroxidschmelze behandelt werden.

## Claims

1. Method for the current-free chemical metallising of a ceramic body, the surface of which is metallised, in particular by copper, chemically and without current after a treatment with an alkali hydroxide bath so that an electrical circuit can be made of it, characterised thereby,

— that the ceramic bodies are initially preheated,

— that the preheated ceramic bodies are treated with an alkali hydroxide bath, which contains water, for a time which lies in a time range of 1 second to 10 hours,

— that the treatment is performed in a protective gas atmosphere,

— that the ceramic bodies are subsequently heated at least to the melting point of the alkali hydroxide as well as subjected to a rinsing treatment,

— that the metallising takes place subsequently thereto,

— that at least one of the ceramic bodies consists of a material containing nitride,

— that the alkali hydroxide bath is formed of a mixture of NaOH and KOH and

— that the alkali hydroxide bath has a water content of 0.01 to 10% by weight.

2. Method for the chemical treatment of ceramic bodies according to claim 1, characterised thereby, that at least one of the ceramic bodies consists of a material containing aluminium nitride.

3. Method for the chemical treatment of ceramic bodies according to claim 1 or claim 2, characterised thereby, that the alkali hydroxide bath is formed of a eutectic mixture of NaOH and KOH (41% by weight of NaOH).

4. Method for the chemical treatment of ceramic bodies according to one of the preceding claims, characterised thereby, that the alkali hydroxide bath has a water content of 1% by weight.

5. Method for the chemical treatment of ceramic bodies according to one of the preceding claims, characterised thereby, that the preheated ceramic bodies are treated with an alkali hydroxide bath, which contains water, for a time duration of 1 to 30 minutes.

**Revendications**

1. Procédé de métallisation chimique d'un corps céramique dont la surface est métallisée chimiquement notamment à l'aide de cuivre après traitement par une masse fondue d'hydroxyde alcalin, de façon à permettre la fabrication d'un circuit électrique, caractérisé en ce que,

— les corps céramiques sont tout d'abord préchauffés,

— les corps céramiques préchauffés sont traités à l'aide d'une masse fondue aqueuse d'hydroxyde alcalin pendant une durée comprise dans une plage de 1 s à 10 h,

— le traitement est réalisé dans une atmosphère de gaz protecteur,

— les corps céramiques sont ensuite chauffés au minimum jusqu'à la température de fusion de l'hydroxyde alcalin et soumis à un rinçage,

— la métallisation est ensuite réalisée,

— au moins un des corps céramiques est en un matériau contenant du nitrure,

— la masse fondue d'hydroxyde alcalin est faite d'un mélange de NaOH-KOH et

— la masse fondue d'hydroxyde alcalin a une teneur en eau comprise entre 0,01 et 10% en poids.

2. Procédé de traitement chimique de corps céramiques selon la revendication 1, caractérisé en ce qu'au moins un des corps céramiques est en un matériau contenant du nitrure d'aluminium.

3. Procédé de traitement chimique de corps céramiques selon la revendication 1 ou la revendication 2, caractérisé en ce que la masse fondue d'hydroxyde alcalin est formée par un mélange eutectique de NaOH-KOH (41% en poids de NaOH).

4. Procédé de traitement chimique de corps céramiques selon l'une des revendications précédentes, caractérisé en ce que la masse fondue d'hydroxyde alcalin a une teneur en eau de 1% en poids.

5. Procédé de traitement chimique de corps céramiques selon l'une des revendications précédentes, caractérisé en ce que les corps céramiques préchauffés sont traités pendant une durée comprise entre 1 et 30 min à l'aide d'une masse fondue aqueuse hydroxyde alcalin.